(19) Europäisches Patentamt
European Patent Office
Office européen des brevets

(11) EP 2 312 666 A1

(12) **EUROPEAN PATENT APPLICATION**
published in accordance with Art. 153(4) EPC

(43) Date of publication:
**20.04.2011 Bulletin 2011/16**

(21) Application number: **09805093.3**

(22) Date of filing: **05.08.2009**

(51) Int Cl.:
***H01L 51/42*** *(2006.01)* ***C08G 61/12*** *(2006.01)*

(86) International application number:
**PCT/JP2009/064214**

(87) International publication number:
**WO 2010/016613 (11.02.2010 Gazette 2010/06)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **06.08.2008 JP 2008202715**

(71) Applicant: **Sumitomo Chemical Company, Limited**
**Tokyo 104-8260 (JP)**

(72) Inventors:
- **MIYAKE, Kunihito**
**Tsukuba-shi**
**Ibaraki 305-0045 (JP)**
- **NOGUCHI, Takanobu**
**Tsukuba-shi**
**Ibaraki 305-0065 (JP)**

(74) Representative: **Vossius & Partner**
**Siebertstrasse 4**
**81675 München (DE)**

# (54) PHOTOELECTRIC CONVERSION ELEMENT

(57) Disclosed is a photoelectric conversion element comprising a pair of electrodes, at least one of which is transparent or translucent, and a photoactive layer provided between the electrodes, wherein the photoactive layer contains an electron donating compound and an electron accepting compound, and the electron donating compound or the electron accepting compound is a polymer compound having a repeating unit represented by the following formula (I), and the proportion of the repeating unit represented by the formula (I) is the highest among all of the repeating units contained in the polymer compound:

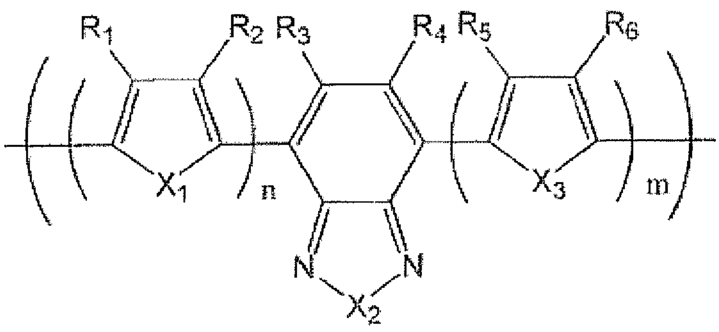

(I)

wherein $R_1$, $R_2$, $R_3$, $R_4$, $R_5$ and $R_6$ are the same or different, repre sent a hydrogen atom or a substituent, and may be linked with one another to form a cyclic structure; $X_1$, $X_2$ and $X_3$ are the same or different and represent a sulfur atom, an oxygen atom, a selenium atom, $-N(R_7)-$ or $-CR_8=CR_9-$; $R_7$, $R_8$, and $R_9$ are the same or different and represent a hydrogen atom or a substituent; and n and m are the same or different and represent an integer of 0 to 5; and when a plurality of $R_1$s, $R_2$s, $R_5$s, $R_6$s, $X_1$s or $X_3$s respectively exist, they may be the same or different.

EP 2 312 666 A1

## Description

### TECHNICAL FIELD

The present invention relates to a photoelectric conversion element comprising a photoactive layer containing a specific polymer compound.

### BACKGROUND ART

In recent years, it is required to reduce quantities of carbon dioxide released into the atmosphere for the prevention of global warming. For example, adoption of a solar system, in which a photoelectrochemical cell such as a silicon solar cell of a p-n junction type is used on the roof of a house, is proposed as a means promising for the reduction in $CO_2$. However, single crystals, polycrystals and amorphous silicon used in the above silicon photoelectrochemical cell have a problem that they are expensive because they require the conditions of high temperature and high vacuum in their production processes.

On the other hand, recently, organic thin film solar cells attract attention since high-temperature and high-vacuum processes can be omitted and there is a possibility that the solar cell can be fabricated at low cost by only an application process. As the organic thin film solar cells, an organic thin film solar cell comprising a photoactive layer composed of a conjugated polymer including repeating units (A) and repeating units (B) as an electron donating compound and an organic electron accepting compound (Applied Physics A 79, 31-35 (2004)) is known. The molar ratio of the repeating units (A) and the repeating units (B) of the conjugated polymer is 0.36:0.33 (Advanced Material 15, 988 (2003)).

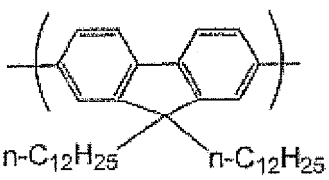

(A)

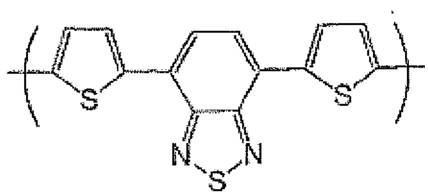

(B)

### DISCLOSURE OF THE INVENTION

However, the photoelectric conversion efficiency of the above-mentioned organic thin film solar cell is low and therefore further improvement in photoelectric conversion efficiency is required. It is an object of the present invention to provide a photoelectric conversion element having high photoelectric conversion efficiency.

The present invention provides, in its first aspect, a photoelectric conversion element comprising a pair of electrodes, at least one of which is transparent or translucent, and a photoactive layer provided between the electrodes, wherein the photoactive layer contains an electron donating compound and an electron accepting compound, and the electron donating compound or the electron accepting compound is a polymer compound having a repeating unit represented by the following formula (I), and the proportion of the repeating unit represented by the formula (I) is the highest among all of the repeating units contained in the polymer compound:

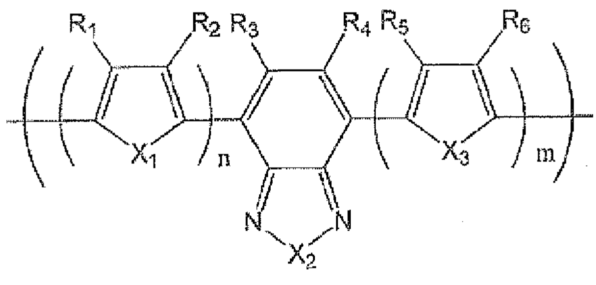

(I)

wherein $R_1$, $R_2$, $R_3$, $R_4$ $R_5$ and $R_6$ are the same or different, represent a hydrogen atom or a substituent, and may be linked with one another to form a cyclic structure; $X_1$, $X_2$ and $X_3$ are the same or different and represent a sulfur atom, an oxygen atom, a selenium atom, $-N(R_7)-$ or $-CP_8=CR_9-$; $R_7$, $R_8$, and $R_9$ are the same or different and represent a hydrogen atom or a substituent; and n and m are the same or different and represent an integer of 0 to 5; and when a plurality of $R_1$s, $R_2$s, $R_5$s, $R_6$s, $X_1$s or $X_3$s respectively exist, they may be the same or different.

The present invention provides, in its second aspect, the photoelectric conversion element wherein n and m are an integer of 1 to 3.

The present invention provides, in its third aspect, the photoelectric conversion element wherein $X_1$, $X_2$ and $X_3$ are a sulfur atom, respectively.

The present invention provides, in its fourth aspect, the photoelectric conversion element wherein an amount of the repeating unit represented by the formula (I) is more than 50% of a total of all repeating units in the polymer compound.

The present invention provides, in its fifth aspect, the photoelectric conversion element wherein an amount of the repeating unit represented by the formula (I) is 52% or more of a total of all repeating units in the polymer compound.

The present invention provides, in its sixth aspect, the photoelectric conversion element wherein an amount of the repeating unit represented by the formula (I) is less than 100% of a total of all repeating units in the polymer compound.

The present invention provides, in its seventh aspect, the photoelectric conversion element wherein an amount of the repeating unit represented by the formula (I) is 98% or less of a total of all repeating units in the polymer compound.

The present invention provides, in its eighth aspect, the photoelectric conversion element wherein the polymer compound further includes a repeating unit represented by the formula (II):

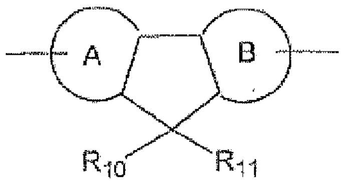

(II)

wherein a ring A and a ring B are the same or different and represent an aromatic ring. $R_{10}$ and $R_{11}$ are the same or different, and represent a hydrogen atom or a substituent, and may be linked with each other to form a cyclic structure.

The present invention provides, in its ninth aspect, the photoelectric conversion element wherein the proportion of the repeating units represented by the formula (II) is the second highest after the proportion of the repeating units represented by the formula (I) among all of the repeating units contained in the polymer compound.

The present invention provides, in its tenth aspect, the photoelectric conversion element wherein the repeating units in the polymer compound are only includes the repeating unit represented by the formula (I) and the repeating unit represented by the formula (II).

The present invention provides, in its eleventh aspect, the photoelectric conversion element wherein $R_1$, $R_2$ , $R_5$ and $R_6$ are a hydrogen atom.

The present invention provides, in its twelfth aspect, the photoelectric conversion element wherein $R_3$ and $R_4$ are a hydrogen atom.

The present invention provides, in its thirteenth aspect, the photoelectric conversion element wherein $R_{10}$ and $R_{11}$ are a hydrocarbon group.

The present invention provides, in its fourteenth aspect, the photoelectric conversion element wherein $R_{10}$ and $R_{11}$ are an alkyl group.

The present invention provides, in its fifteenth aspect, the photoelectric conversion element wherein $R_{10}$ has 12 or more carbon atoms and $R_{11}$ has 12 or more carbon atoms.

The present invention provides, in its sixteenth aspect, the photoelectric conversion element wherein the ring A and the ring B are composed of from a five-membered ring to a ten-membered ring.

The present Invention provides, in its seventeenth aspect, the photoelectric conversion element wherein the ring A and the ring B are a benzene ring or a naphthalene ring.

The present invention provides, in its eighteenth aspect, the photoelectric conversion element wherein an electron donating compound is the polymer compound having a repeating unit represented by the formula (I) and an electron accepting compound is a polymer compound having a thiophene structure.

The present invention provides, in its nineteenth aspect, the photoelectric conversion element wherein an

electron accepting compound is the polymer compound having a repeating unit represented by the formula (I) and an electron donating compound is a polymer compound having a thiophene structure.

The present invention provides, in its twentieth aspect, the photoelectric conversion element wherein the polymer compound having a thiophene structure is a polythiophene homopolymer.

The present invention provides, in its twenty-first aspect, an image sensor including the photoelectric conversion element.

The present invention provides, in its twenty-second aspect, a polymer compound having a repeating unit represented by the following formula (I), and the proportion of the repeating unit represented by the formula (I) is the highest among all of the repeating units contained in the polymer compound:

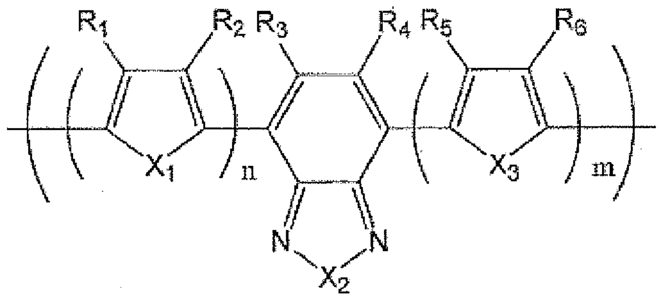

(I)

wherein $R_1$, $R_2$, $R_3$, $R_4$, $R_5$ and $R_6$ are the same or different and represent a hydrogen atom or a substituent, and may be linked with one another to form a cyclic structure; $X_1$, $X_2$ and $X_3$ are the same or different and represent a sulfur atom, an oxygen atom, a selenium atom, $-N(R_7)-$ or $-CR_8=CR_9-$; $R_7$, $R_8$, and $R_9$ are the same or different and represent a hydrogen atom or a substituent; and n and m are the same or different and represent an integer of 0 to 5; and when a plurality of $R_1$s, $R_2$s, $R_5$s, $R_6$s, $X_1$s or $X_3$s respectively exist, they may be the same or different.

## MODE FOR CARRYING OUT THE INVENTION

Hereinafter, the present invention will be described in detail.

In the formula (1), n and m are the same or different and represent an integer of 0 to 5. The n and m are preferably an integer of 1 to 3, and more preferably 1.

$R_1$, $R_2$, $R_3$, $R_4$, $R_5$ and $R_6$ are the same or different, and represent a hydrogen atom or a substituent. When $R_1$ to $R_6$ are a substituent, the substituent preferably has 1 to 30 carbon atoms. Examples of the substituents include alkyl groups such as a methyl group, an ethyl group, a butyl group, a hexyl group, an octyl group and a dodecyl group; alkoxy groups such as a methoxy group, an ethoxy group, a butoxy group, a hexyloxy group, an octyloxy group and a dodecyloxy group; and aryl groups such as a phenyl group and a naphthyl group.

$R_1$, $R_2$, $R_3$, $R_4$, $R_5$ and $R_6$ may be linked with one another to form a cyclic structure.

Examples of the cyclic structures formed by the linkage of $R_1$ and $R_2$ and the linkage of $R_5$ and $R_6$ include the following cyclic structure.

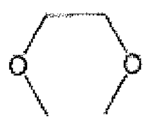

Examples of the cyclic structures formed by the linkage of $R_3$ and $R_4$ include the following cyclic structure:

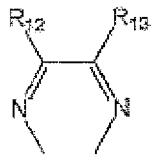 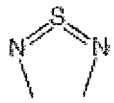 ,

wherein $R_{12}$ and $R_{13}$ are the same or different, and represent a hydrogen atom or a substituent.

Examples of the substituents represented by $R_{12}$ and $R_{13}$ include the same groups as the substituents represented by $R_1$ to $R_6$ described above.

The $R_1$ to $R_6$ are preferably a hydrogen atom or alkyl groups, and more preferably a hydrogen atom.

$X_1$, $X_2$ and $X_3$ are the same or different and represent a sulfur atom, an oxygen atom, a selenium atom, $-N(R_7)-$ or $-CR_8=CR_9-$. $R_7$, $R_8$ and $R_9$ are the same or different and represent a hydrogen atom or a substituent. When $R_7$, $R_8$ and $R_9$ are a substituent, examples of the substituents include alkyl groups such as a methyl group, an ethyl group, a butyl group, a hexyl group, an octyl group and a dodecyl group; and aryl groups such as a phenyl group and a naphthyl group.

$X_1$, $X_2$ and $X_3$ are preferably a sulfur atom, respectively.

The repeating unit represented by the formula (I) is preferably a repeating unit represented by the formula (I-1).

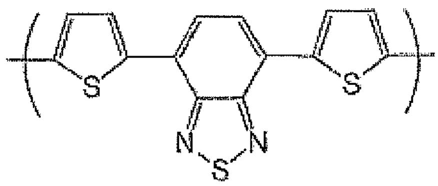

(I-1)

The polymer compound used in the present invention is a polymer compound having a repeating unit represented by the formula (I), wherein the content (molar number) of the repeating unit represented by the formula (I) is the highest among all of the repeating units in the polymer compound.

In the polymer compound used in the present invention, a polymer compound, in which an amount of the repeating unit represented by the formula (I) is more than 50% of a total of all repeating units in the polymer compound, is preferable. The photoelectric conversion element containing a polymer compound in which an amount of the repeating unit represented by the formula (I) is more than 50% has higher photoelectric conversion efficiency than that of the photoelectric conversion element using a polymer compound in which the repeating unit represented by the formula (I) is 50% or less. More preferably, an amount of the repeating units represented by the formula (I) is 52% or more of a total of all repeating units in the polymer compound. Furthermore preferably, an amount of the repeating units represented by the formula (I) is 55% or more of a total of all repeating units in the polymer compound.

An amount of the repeating unit represented by the formula (I) preferably is less than 100% of a total of all repeating units in the polymer compound. More preferably, an amount of the repeating unit represented by the formula (I) is 98% or less of a total of all repeating units in the polymer compound. Furthermore preferably, an amount of the repeating unit represented by the formula (I) is 70% or less of a total of all repeating units in the polymer compound. The polymer compound used in the present invention preferably includes another repeating unit other than the repeating unit represented by the formula (I).

The polymer compound used in the present invention may further include a repeating unit represented by the formula (II):

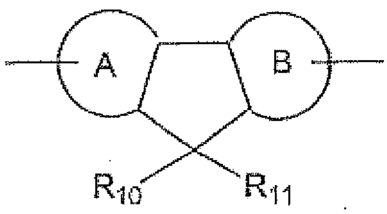

(II)

wherein a ring A and a ring B are the same or different and represent an aromatic ring, and $R_{10}$ and $R_{11}$ are the same or different, represent a hydrogen atom or a substituent, and may be linked with each other to form a cyclic structure.

When $R_{10}$ and $R_{11}$ are a substituent, examples of the substituents include alkyl groups such as a methyl group, an ethyl group, a butyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group and an eicosyl group; and aryl groups such as a phenyl group and a naphthyl group. $R_{10}$ and $R_{11}$ are preferably a hydrocarbon group such as alkyl groups and aryl groups, and more preferably alkyl groups. When $R_{10}$ and $R_{11}$ are a substituent, the substituent preferably has 12 or more carbon atoms.

Examples of the ring A and the ring B include aromatic hydrocarbon rings such as a benzene ring and a naphthalene ring, and aromatic heterocyclic rings such as thiophene. The ring A and the ring B are preferably composed of from a five-membered ring to a ten-membered ring, and are more preferably a benzene ring or a naphthalene ring.

The repeating unit represented by the formula (II) is preferably a repeating unit represented by the formula (II-1):

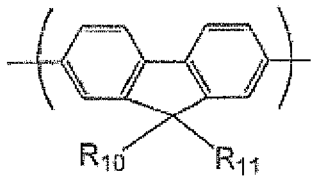

(II-1)

wherein $R_{10}$ and $R_{11}$ represent the same as those described above.

When the polymer compound used in the present invention has the repeating unit represented by the formula (II) in addition to the repeating unit represented by the formula (I), it is preferable that the proportion of the repeating unit represented by the formula (II) is the second highest after the proportion of the repeating unit represented by the formula (I) among all of the repeating units contained in the polymer compound, and it is more preferable that the repeating units in the polymer compound only has the repeating unit represented by the formula (I) and the repeating unit represented by the formula (II).

<Method of Producing Polymer Compound>

A method of producing the polymer compound used in the present invention is not particularly limited, but a method in which a Suzuki coupling reaction is used is preferable in point of ease of synthesis of the polymer compound.

Examples of the methods of using the Suzuki coupling reaction include a production method comprising the step of reacting one or more compounds represented by the formula (100):

$$Q_1-E_1-Q_2 \qquad (100),$$

wherein $E_1$ represents the same group as one of the formula (II), and $Q_1$ and $Q_2$ are the same or different and represent a boronic acid residue or a borate residue, with one or more compounds represented by the formula (200):

$$T_1-E_2-T_2 \qquad (200),$$

wherein $E_2$ represents the groups as one of the formula (I), and $T_1$ and $T_2$ are the same or different and represent a halogen atom, an alkylsulfonate group, an arylsulfonate group or an arylalkylsulfonate group, in the presence of a palladium catalyst and a base.

In this case, it is required that a total of molar numbers of one or more compounds represented by the formula (200) to be used in the reaction exceeds a total of molar numbers of one or more compounds represented by the formula (100). When the total of molar numbers of one or more compounds represented by the formula (200) to be used in the reaction is taken as 1 mol, the total of molar numbers of one or more compounds represented by the formula (100) is preferably, 0.6 to 0.99 mol, and more preferably 0.7 to 0.95 mol.

Examples of the borate residue include groups represented by the following formula:

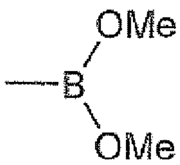
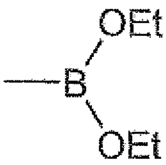
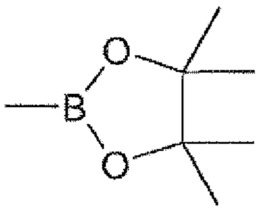
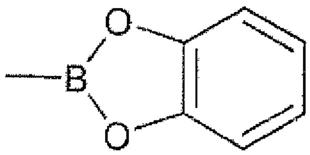

wherein Me represents a methyl group, and Et represents an ethyl group.

Examples of the halogen atoms in $T^1$ and $T^2$ in the formula (200) include a fluorine atom, a chlorine atom, a bromine atom, and an iodine atom. The bromine atom and the iodine atom are preferable and the bromine atom is more preferable in point of ease of synthesis of the polymer compound.

Examples of the alkylsulfonate groups in $T^1$ and $T^2$ in the formula (200) include a methanesulfonate group, an ethanesulfonate group, and a trifluoromethanesulfonate group. Examples of the arylsulfonate groups include a benzenesulfonate group and a p-toluenesulfonate group. Examples of the arylsulfonate groups include a benzylsulfonate group.

Specifically, as the catalyst, for example, palladium[tetrakis(triphenylphosphine)], palladium acetates or dichlorobis(triphenylphosphine)palladium(II) is used, and an inorganic base such as potassium carbonate, sodium carbonate, barium hydroxide or the like, an organic base such as triethylamine or the like, or an inorganic salt such as cesium fluoride or the like is added in an equivalent amount or more, preferably in 1 to 20 equivalent amount with respect to a monomer to react the resulting mixture. Examples of a solvent include N,N-dimethylformamide, toluene, dimethoxyethane, and tetrahydrofuran. The base is added as an aqueous solution and may be reacted in a two-phase system. When the base is reacted in a two-phase system, a phase-transfer catalyst such as quaternary ammonium salt may be added as required. Depending on a solvent, as a reaction temperature, a temperature of about 50 to 160°C is suitably employed. A reactant may be heated to almost a boiling point of the solvent and may be refluxed. A reaction time is about 0.1 to 200 hours. In addition, the reaction is carried out under the condition, in which a catalyst is not deactivated, in an atmosphere of inert gas such as argon gas, nitrogen gas or the like.

Palladium Catalyst

Examples of the palladium catalyst to be used in a production method of the polymer compound used in the present invention include palladium[tetrakis(triphenylphosphine)], palladium acetates and dichlorobis(triphenylphosphine)palladium(II) including a Pd(0) catalyst and a Pd(II) catalyst, and dichlorobis(triphenylphosphine)palladium(II) and palladium acetates are preferable from the viewpoint of ease of a reaction (polymerization) operation and a reaction (polymerization) rate.

The additive amount of the palladium catalyst is not particularly limited as long as it is an effective amount as a catalyst, and it is usually 0.0001 to 0.5 mol, and preferably 0.0003 to 0.1 mol with respect to 1 mol of the compound represented by the formula (100).

Base

Examples of the base to be used in a production method of the polymer compound used in the present invention include inorganic bases, organic bases and inorganic salts. Examples of the inorganic bases include potassium carbonate, sodium carbonate, and barium hydroxide. Examples of the organic bases include triethylamine, and tributylamine. Examples of the inorganic salts include cesium fluoride.

The additive amount of the base is usually 0.5 to 100 mol, preferably 0.9 to 20 mol, and more preferably 1 to 10 mol with respect to 1 mol of the compound represented by the formula (100).

· Other Components

When palladium acetates are used as the palladium catalyst, phosphorus compounds such as triphenylphosphine,
tri (o-tolyl)phosphine and tri(o-methoxyphenyl)phosphine can be added as a ligand. In this case, the additive amount of the ligand is usually 0.5 to 100 mol, preferably 0.9 to 20 mol, and more preferably 1 to 10 mol with respect to 1 mol of the palladium catalyst.

In the production method of the polymer compound used in the present invention, the above-mentioned reaction is commonly carried out in a solvent. Examples of the solvent include N,N-dimethylformamide, toluene, dimethoxyethane, and tetrahydrofuran. Toluene and tetrahydrofuran are preferable from the viewpoint of the solubility of the polymer compounds used in the present invention. The base is added as an aqueous solution and may be reacted in a two-phase system. When an inorganic salt is used as the base, the inorganic salt is commonly added as an aqueous solution from the viewpoint of the solubility of the inorganic salt and is reacted in a two-phase system.

In addition, when the base is added as an aqueous solution and reacted in a two-phase system, a phase-transfer catalyst such as quaternary ammonium salt may be added as required.

· Reaction Condition

Depending on the solvent, a temperature at which the reaction is carried out is usually 50 to 160°C, and preferably 60 to 120°C from the viewpoint of increasing a molecular weight of the polymer compound. A reactant may be heated to almost a boiling point of the solvent and may be refluxed. Although a period of time, during which the reaction is carried out, (reaction time) may be a period of time in the case where the time when reaching a desired polymerization degree is taken as a reaction end point, but it is usually about 0.1 to 200 hours although. The reaction time of about 1 to 30 hours is efficient and preferable.

The reaction is carried out in a reaction system, in which a Pd (0) catalyst is not deactivated, in an atmosphere of inert gas such as an argon gas, a nitrogen gas or the like. For example, the reaction is carried out in a system which is adequately deaerated with an argon gas or a nitrogen gas. Specifically, after the inside of a polymerization vessel (reaction system) is adequately replaced and deaerated with a nitrogen gas, into the polymerization vessel, a compound represented by the formula (100), a compound represented by the formula (200) and dichlorobis(triphenylphosphine) palladium(II) are charged, and further the inside of the polymerization vessel is adequately replaced with a nitrogen gas and deaerated, and then a solvent which had been previously deaerated by being bubbled, for example, toluene was added, and then to the resulting solution, a base which had been previously deaerated by being bubbled with a nitrogen gas, for example, an aqueous solution of sodium carbonate is added dropwise. Thereafter, the resulting solution is heated and the temperature is elevated, for example, at a reflux temperature for 8 hours while maintaining an inert atmosphere.

A number average molecular weight on the polystyrene equivalent basis of the polymer compound used in the present invention is $1 \times 10^3$ to $1 \times 10^8$, and preferably $2 \times 10^3$ to $1 \times 10^7$. When the number average molecular weight on the polystyrene equivalent basis is $1 \times 10^3$ or more, a tough thin film can be easily attained. On the other hand, when the number average molecular weight is $10^8$ or less, the solubility of the polymer compound is high and it is easy to prepare a thin film. A weight average molecular weight on the polystyrene equivalent basis is usually $1.1 \times 10^3$ to $1.1 \times 10^8$, and preferably $2.2 \times 10^3$ to $1.1 \times 10^7$.

A terminal group of the polymer compound used in the present invention may be protected by a stable group since if a polymerizable active group remains at the end group, characteristics and life of a resulting element can be deteriorated when the polymer compound is used for preparation of the element. The terminal group having a conjugated bond continuously connected to a conjugated structure of a main chain is preferable, and for example, a structure, in which the end group is coupled with an aryl group or a heterocyclic group with a vinylene group interposed therebetween, may be employed. Specifically, the substituents described as [Chem 10] in JP Hei-9-45478A are shown.

<Photoelectric Conversion Element>

The photoelectric conversion element of the present invention comprises one or more photoactive layers containing the polymer compound of the present invention between a pair of electrodes, at least one of which is transparent or translucent.

The photoelectric conversion element of the present invention preferably comprises a pair of electrodes, at least one of which is transparent or translucent, and a photoactive layer formed from an organic composition of a p-type organic semiconductor and an n-type organic semiconductor. An operating mechanism of the photoelectric conversion element of this form will be described. Light energy passing through the transparent or translucent electrode is absorbed by an electron accepting compound (n-type organic semiconductor) such as fullerene derivatives and/or an electron donating compound (p-type organic semiconductor) such as a conjugated polymer compound to produce an exciton in which an electron and a hole are combined into one. When the produced exciton moves and reaches a hetero junction interface where the electron accepting compound and the electron donating compound exist next to each other, the exciton is separated into the electron and the hole due to a difference between HOMO (highest occupied molecular orbital) energy and LUMO (lowest unoccupied molecular orbital) energy at the interface to generate charges (electron and hole) which can independently move. The generated charges are respectively travel to electrodes, and thereby the charges can be externally drawn out as electric energy (electric current).

The photoelectric conversion element of the present invention is generally formed on a substrate. It is preferred that the substrate is not deformed when an electrode is formed and an organic material layer is formed on the substrate. Examples of the materials of the substrate include glass, plastic, polymer film, and silicon. When the substrate is an opaque substrate, an opposite electrode (that is, an electrode on a side far from the substrate) is preferably a transparent or translucent electrode.

Examples of materials of the transparent or translucent electrode include conductive metal oxide films, and translucent metal thin films. Specifically, films (NESA, etc.) prepared by use of conductive materials comprising indium oxide, zinc oxide, tin oxide and composites thereof, for example, indium tin oxide (ITO) and indium zinc oxide (IZO), or gold, platinum, silver or copper is used, and ITO, indium zinc oxide and tin oxide are preferable. Examples of a method for preparing the electrode include a vacuum deposition method, a sputtering method, an ion plating method, and a plating method. As an electrode material, organic transparent conductive films such as polyaniline and derivatives thereof, polythiophene and derivatives thereof and the like may be used. Moreover, as the electrode material, metals or conductive polymers can be further used. A material of one electrode of the pair of electrodes is preferably a material having a small work function. As such materials, metals such as lithium, sodium, potassium, rubidium, cesium, magnesium, calcium, strontium, barium, aluminum, scandium, vanadium, zinc, yttrium, indium, cerium, samarium, europium, terbium or ytterbium, or alloys of two or more thereof; alloys of one or more of the above-mentioned metals and one or more of gold, silver, platinum, copper, manganese, titanium, cobalt, nickel, tungsten and tin; or graphite or graphite interlayer compounds are used. Examples of the alloys include magnesium-silver alloy, magnesium-indium alloy, magnesium-aluminum alloy, indium-silver alloy, lithium-aluminum alloy, lithium-magnesium alloy, lithium-indium alloy, and calcium-aluminum alloy.

An additional intermediate layer other than the photoactive layer may be used as a means of improving photoelectric conversion efficiency. Examples of a material used as an intermediate layer include alkali metal such as lithium fluoride and the like, and halide and oxide of alkaline earth metals. Further, examples of a material of the intermediate layer include fine particles of inorganic semiconductor such as titanium oxide and PEDOT (poly-3,4-ethylenedioxythiophene).

<Photoactive Layer>

The photoactive layer may contain one polymer compound of the present invention alone, or may contain the polymer compounds in combination of two or more species. In order to enhance a hole transporting property of the photoactive layer, a low molecular compound and/or a polymer compound other than the polymer compound of the present invention can be mixed in the photoactive layer as the electron donating compound and/or the electron accepting compound.

Examples of the electron donating compounds include, in addition to the polymer compounds of the present invention, pyrazoline derivatives, arylamine derivatives, stilbene derivatives, triphenyldiamine derivatives, oligothiophene and derivatives thereof, polyvinylcarbazole and derivatives thereof, polysilane and derivatives thereof, polysiloxane derivatives having aromatic amine on the side chain or main chain, polyaniline and derivatives thereof, polythiophene and derivatives thereof, polypyrrole and derivatives thereof, polyphenylenevinylene and derivatives thereof, and polythienylenevinylene and derivatives thereof.

Examples of the electron accepting compound include, in addition to the polymer compounds of the present invention, oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, metal complex of 8-hydroxyquinoline and derivatives thereof, polyquinoline and derivatives thereof, polyquinoxaline and derivatives thereof, polyfluorene and derivatives thereof, fullerenes such as $C_{60}$ and the like and derivatives thereof, and phenanthrene derivatives such as bathocuproin, and particularly, fullerenes and derivatives thereof are preferable.

The electron donating compound and the electron accepting compound are determined based on a relative level of the energy level of these compounds.
The photoactive layer contained in the photoelectric conversionelement of the present invention contains the electron donating compound and the electron accepting compound. One of the electron donating compound and the electron accepting compound is a polymer compound having a repeating unit represented by the formula (I), and the other of the electron donating compound and the electron accepting compound is a compound which is used in conjunction with the polymer compound having a repeating unit represented by the formula (I) in the photoactive layer. When levels of HOMO energy and LUMO energy of the polymer compound having a repeating unit represented by the formula (I) are shallower than levels of HOMO energy and LUMO energy of the other compound used in combination, the polymer compound having a repeating unit represented by the formula (I) acts as an electron donating compound.
One aspect of the photoelectric conversion element of the present invention uses the polymer compound having a repeating unit represented by the formula (I) as an electron donating compound. As the electron accepting compounds in the present aspect, fullerenes, fullerene derivatives, carbon nanotubes, and carbon nanatube derivatives are preferable.
Examples of the fullerenes include C60 fullerene, C70 fullerene, C76 fullerene, C78 fullerene, and C84 fullerene.
Examples of the fullerene derivatives include [6,6]-phenyl-$C_{61}$-butyric acid methyl ester (C60 PCBM), [6,6]-phenyl-$C_{71}$-butyric acid methyl ester (C70 PCBM), [6,6]-phenyl-$C_{85}$-butyric acid methyl ester (C84 PCBM), and [6,6]-thienyl-$C_{61}$-butyric acid methyl ester (C60 PCBM).
When the fullerene derivative is used as an electron accepting compound, a rate of the fullerene derivative is preferably 10 to 1000 parts by weight, and more preferably 20 to 500 parts by weight with respect to 100 parts by weight of the electron donating compound.
When levels of HOMO energy and LUMO energy of the polymer compound having a repeating unit represented by the formula (I) are lower than levels of HOMO energy and LUMO energy of the other compound used in combination, the polymer compound having a repeating unit represented by the formula (I) acts as an electron accepting compound.
One aspect of the photoelectric conversion element of the present invention uses the polymer compound having a repeating unit represented by the formula (I) as an electron accepting compound. In this case, as the electron donating compounds, the polymer compound having a thiophene structure is preferable. The polymer compound having a thiophene structure is more preferably a polythiophene homopolymer. The polythiophene polymer is a polymer formed by combining a plurality of constituent units selected from thiophenediyl groups and substituted thiophenediyl groups. As the thiophenediyl groups, a thiophene-2, 5-diyl group is preferable, and as the substituted thiophenediyl groups, an alkylthiophene-2,5-diyl group is preferable.
Examples of the polythiophene homopolymers include poly(3-hexylthiophene-2,5-diyl) (P3HT),
poly(3-octylthiophene-2,5-diyl),
poly(3-dodecylthiophene-2,5-diyl), and
poly(3-octadecylthiophene-2,5-diyl). Among the polythiophene homopolymers, polythiophene homopolymers replaced with an alkyl group having 6 to 30 carbon atoms are preferable.
The thickness of the photoactive layer is usually 1 nm to 100 μm, preferably 2 nm to 1000 nm, more preferably 5 nm to 500 nm, and furthermore preferably 20 nm to 200 nm.

<Method of Fabricating Photoactive Layer>

As a method of fabricating a photoactive layer, any method may be employed to fabricate the photoactive layer, and examples of the methods include a method of forming a film from a solution containing a polymer compound, and a method of forming a film by a vacuum deposition method.
A solvent to be used for forming a film from a solution is not particularly limited as long as the polymer compound (polymer) of the present invention is dissolved in the solvent. Examples of the solvent include unsaturated hydrocarbon solvents such as toluene, xylene, mesitylene, tetralin, decalin, bicyclohexyl, n-butylbenzene, sec-butylbenzene and tert-butylbenzene; halogenated saturated hydrocarbon solvents such as carbon tetrachloride, chloroform, dichloromethane, dichloroethane, chlorobutane, bromobutane, chloropentane, bromopentane, chlorohexane, bromohexane, chlorocyclohexane and bromocyclohexane; halogenated unsaturated hydrocarbon solvents such as chlorobenzene, dichlorobenzene and trichlorobenzene; and ether solvents such as tetrahydrofuran and tetrahydropyran. The polymer compound (polymer) of the present invention can be generally dissolved in the above solvent in an amount 0.1% by weight or more.
For forming a film, application methods, such as a spin coating method, a casting method, a microgravure coating method, a gravure coating method, a bar coating method, a roll coating method, a wire bar coating method, a dip coating method, a spray coating method, a screen printing method, a gravure printing method, a flexo printing method, an offset printing method, an ink jet printing method, a dispenser printing method, a nozzle coating method and a capillary coating method, can be used, and the spin coating method, the flexo printing method, the gravure printing method, the ink jet printing method, and the dispenser printing method are preferably used.

<Application of Element>

The photoelectric conversion element of the present invention can be operated as an organic thin film solar cell since a photovoltaic power is generated between electrodes by being irradiated from a transparent or translucent electrode with light such as solar light. The photoelectric conversion element of the present invention can also be used as an organic thin film solar cell module by integrating a plurality of organic thin film solar cells.

The photoelectric conversion element of the present invention can be operated as an organic optical sensor since a photocurrent flows by being irradiated from a transparent or translucent electrode with light in a state of applying or not applying a voltage between the electrodes. The photoelectric conversion element of the present invention can also be used as an organic image sensor by integrating a plurality of organic optical sensors.

EXAMPLES

Hereinafter, examples will be described in order to explain the present invention in more detail, but the present invention is not limited to these examples.

(Synthesis Example 1)

Production of Polymer A

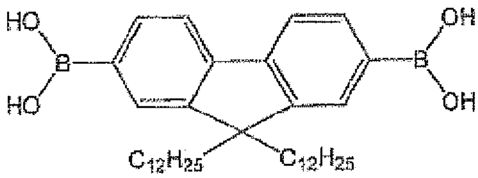

(1)

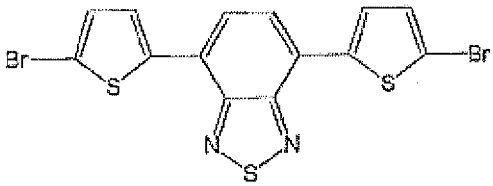

(2)

0.945 g (1. 60 nmol) of the monomer (1), 0. 918 g (2.00 mol) of the monomer (2), and 25 mg of tetrakis (triphenylphosphine)palladium(0) were charged into a reaction vessel, and the inside of the reaction vessel was adequately replaced with an argon gas. To the reaction vessel, 50 g of toluene, which had been previously deaerated by being bubbled with an argon gas, was added. The resulting solution was stirred at 100°C for about 10 minutes. Next, to the resulting solution, 5 ml of a tetraethylammonium hydroxide solution (20% aqueous solution), which had been previously deaerated by being bubbled with an argon gas, was added dropwise, and then the mixed solution was refluxed for 3.5 hours. Next, to the resulting reaction solution, 0.55 g of phenylboric acid was added, and the resulting mixture was refluxed for 8.5 hours. A reaction was performed in an argon gas atmosphere.

After the completion of the reaction, the reactant solution was cooled to almost room temperature and then left to stand to separate a toluene layer, and the toluene layer was obtained. Then, the obtained toluene layer was poured into methanol to be reprecipitated, and a produced precipitate was collected. The precipitate was dried under a reduced pressure and then dissolved in chloroform. Next, the obtained chloroform solution was filtered to remove insoluble substances and then passed through an alumina column to be purified. Then, the resulting chloroform solution was

concentrated under a reduced pressure, poured into methanol to be reprecipitated, and a produced precipitate was collected. The precipitate was washed with methanol and dried under a reduced pressure to obtain 0. 93 g of a polymer. Hereinafter, this polymer is referred to as a polymer A. A weight average molecular weight on the polystyrene equivalent basis of the polymer A was $2.0 \times 10^4$ and a number average molecular weight on the polystyrene equivalent basis was $4.7 \times 10^3$.

A ratio of a repeating unit represented by the formula (2'), which was calculated from a charging ratio, among all of the repeating units of the polymer A was 55.6%.

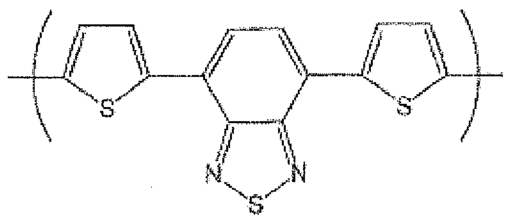

(2')

(Synthesis Example 2)

Production of Polymer B

1.063g (1.80mol) of the monomer (1), 0.756 g (1.65mmol) of the monomer (2), and 25 mg of tetrakis(triphenylphosphine)palladium(0) were charged into a reaction vessel, and the inside of the reaction vessel was adequately replaced with an argon gas. To the reaction vessel, 50 g of toluene, which had been previously deaerated by being bubbled with an argon gas, was added. The resulting solution was stirred at 100°C for about 10 minutes. Next, to the resulting solution, 5 ml of a tetraethylammonium hydroxide solution (20% aqueous solution), which had been previously deaerated by being bubbled with an argon gas, was added dropwise, and then the mixed solution was refluxed for 2.5 hours. To the resulting reaction solution, 0.25 g of bromobenzene was added, and the resulting mixture was refluxed for 1 hour. Then, 0.30 g of phenylboric acid was added to the resulting reaction solution, and the resulting mixture was refluxed for 8.5 hours. A reaction was performed in an argon gas atmosphere.

After the completion of the reaction, the reactant solution was cooled to almost room temperature and then left to stand to separate a toluene layer, and the toluene layer was obtained. Then, the obtained toluene layer was poured into methanol to be reprecipitated, and a produced precipitate was collected. The precipitate was dried under a reduced pressure and then dissolved in chloroform. Next, the obtained chloroform solution was filtered to remove insoluble substances and then passed through an alumina column to be purified. Then, the resulting chloroform solution was concentrated under a reduced pressure, poured into methanol to be reprecipitated, and a produced precipitate was collected. The precipitate was washed with methanol and dried under a reduced pressure to obtain 1.0 g of a polymer. Hereinafter, this polymer is referred to as a polymer B. A weight average molecular weight on the polystyrene equivalent basis of the polymer B was $6.5 \times 10^4$ and a number average molecular weight on the polystyrene equivalent basis was $1.4 \times 10^3$.

A ratio of a repeating unit represented by the formula (2'), which was calculated from a charging ratio, among all of the repeating units of the polymer B was 47.8%.

(Synthesis Example 3)

Production of Polymer C

14.172 g (24.0 mmol) of the monomer (1), 13.746 g (30.0 mmol) of the monomer (2), 6.75 g of methyltrioctylammonium chloride (trade same: aliquat 336, manufactured by Aldrich Chemical Company, Inc., $CH_3N[(CH_2)_7CH_3]_3Cl$, density 0. 884 g/ml at 25°C, trademark of Henkel Corporation), 62.6 mg of palladium(II) acetate, and 338 mg of tris(2-methoxyphenyl)phosphine were charged into a reaction vessel, and the inside of the reaction vessel was adequately replaced with an argon gas. To the reaction vessel, 600 g of toluene, which had been previously deaerated by being bubbled with an argon gas, was added. Next, to the resulting solution, 150 ml of a 16.7 weight % aqueous solution of sodium carbonate, which had been previously deaerated by being bubbled with an argon gas, was added dropwise, and then the mixed solution was heated to a temperature at which the solvent was refluxed, and refluxed for 8 hours. A reaction was performed in an argon gas atmosphere.

Then, the resulting reaction solution was cooled, and to this, a mixed solution of 3.0 g of phenylboric acid and 7.0 ml of tetrahydrofuran was added, and the resulting mixture was refluxed for 9 hours. A reaction was performed in an argon gas atmosphere.

After the completion of the reaction, the resulting reactant solution was cooled and then left to stand to separate a toluene layer, and the toluene layer was obtained. Next, the obtained toluene layer was poured into methanol to be reprecipitated, and a produced precipitate was collected. The precipitate was dried under a reduced pressure and then dissolved in chloroform. Next, the obtained chloroform solution was filtered to remove insoluble substances and then passed through an alumina column tobe purified. Then, the resulting chloroform solution was concentrated under a reduced pressure, poured into methanol to be reprecipitated, and a produced precipitate was collected. The precipitate was washed with methanol and dried under a reduced pressure to obtain 14.8 g of a polymer. Hereinafter, this polymer is referred to as apolymer C. A weight average molecular weight on the polystyrene equivalent basis of the polymer C was $2.8 \times 10^4$ and a number average molecular weight on the polystyrene equivalent basis was $8.3 \times 10^3$.

A ratio of a repeating unit represented by the formula (2'), which was calculated from a charging ratio, among all of the repeating units of the polymer C was 55.6%.

(Synthesis Example 4)

Production of Polymer D

0.473 g (0.801 mmol) of the monomer (1), 0.450 g (0.983 mmol) of the monomer (2), 0.33 g of methyltrioctylammonium chloride (trade name: aliquat 336, manufactured by Aldrich Chemical Company, Inc., $CH_3N$ $[(CH_2)_7CH_3]Cl$, density 0.884 g/ml at 25°C, trademark of Henkel Corporation), 2.0mg of palladium(II) acetate, 23 mg of tris (2-methoxyphenyl) phosphine, and 49 mg of phenylboric acid were charged into a reaction vessel, and the inside of the reaction vessel was adequately replaced with an argon gas. To the reaction vessel, 40 ml of toluene, which had been previously deaerated by being bubbled with an argon gas, was added. Next, to the resulting solution, 5 ml of a 16.7 weight% aqueous solution of sodium carbonate, which had been previously deaerated by being bubbled with an argon gas, was added dropwise, and then the mixed solution was heated to a temperature at which the solvent was refluxed, and refluxed for 17 hours. A reaction was performed in an argon gas atmosphere.

After the completion of the reaction, the resulting reactant solution was cooled and then left to stand to separate a toluene layer, and the toluene layer was obtained. Next, the obtained toluene layer was poured into methanol to be reprecipitated, and a produced precipitate was collected. The precipitate was dried under a reduced pressure and then dissolved in chloroform. Next, the obtained chloroform solution was filtered to remove insoluble substances and then passed through an alumina column to be purified. Then, the resulting chloroform solution was concentrated under a reduced pressure, poured into methanol to be reprecipitated, and a produced precipitate was collected. The precipitate was washed with methanol and dried under a reduced pressure to obtain 0.34 g of a polymer. Hereinafter, this polymer is referred to as a polymer D. A weight average molecular weight on the polystyrene equivalent basis of the polymer D was $1.3 \times 10^4$ and a number average molecular weight on the polystyrene equivalent basis was $6.6 \times 10^3$.

A ratio of a repeating unit represented by the formula (2'), which was calculated from a charging ratio, among all of the repeating units of the polymer D was 55.1%.

(Synthesis Example 5)

Production of Polymer E

0.360 g (0.610 mmol) of the monomer (1), 0.458 g (1.00 mmol) of the monomer (2), 0.37 g of methyltrioctylammonium chloride (trade name: aliquat 336, manufactured by Aldrich Chemical Company, Inc., $CH_3N[(CH_2)_7CH_3]Cl$, density 0.884 g/ml at 25°C, trademark of Henkel Corporation), 2.0mg of palladium(II) acetate, 10.8 mg of tris(2-methoxyphenyl)phosphine, and 98 mg of phenylboric acid were charged into a reaction vessel, and the inside of the reaction vessel was adequately replaced with an argon gas. To the reaction vessel, 40 ml of toluene, which had been previously deaerated by being bubbled with an argon gas, was added. Next, to the resulting solution, 5ml of a 26.7 weight % aqueous solution of sodium carbonate, which had been previously deaerated by being bubbled with an argon gas, was added dropwise, and then the mixed solution was heated to a temperature at which the solvent was refluxed, and refluxed for 17 hours. A reaction was performed in an argon gas atmosphere.

After the completion of the reaction, the resulting reactant solution was cooled and then left to stand to separate a toluene layer, and the toluene layer was obtained. Next, the obtained toluene layer was poured into methanol to be reprecipitated, and a produced precipitate was collected. The precipitate was dried under a reduced pressure and then dissolved in chloroform. Next, the obtained chloroform solution was filtered to remove insoluble substances and then passed through an alumina column to be purified. Then, the resulting chloroform solution was concentrated under a

reduced pressure, poured into methanol to be reprecipitated, and a produced precipitate was collected. The precipitate was washed with methanol and dried under a reduced pressure to obtain 0.27 g of a polymer. Hereinafter, this polymer is referred to as a polymer E. A weight average molecular weight on the polystyrene equivalent basis of the polymer E was $6.0 \times 10^3$ and a number average molecular weight on the polystyrene equivalent basis was $2.5 \times 10^3$.

A ratio of a repeating unit represented by the formula (2'), which was calculated from a charging ratio, among all of the repeating units of the polymer E was 62.1%.

Example 1

(Preparation and Evaluation of Organic Thin Film Solar Cell)

A glass substrate provided with an ITO film of 150 nm in thickness by a sputtering method was surface treated by an ozone UV treatment. Next, an ortho-dichlorobenzene solution (a weight ratio of polymer A to PCBM is 1/3) containing the polymer A of a polymer compound and C60 PCBM (phenyl-$C_{61}$-butyric acid methyl ester, manufactured by Frontier Carbon Corp.) of a fullerene derivative was used and the solution was applied by spin coating to prepare a photoactive layer (film thickness about 100 nm). Then, lithium fluoride was deposited in a thickness of 4 nm by a vacuum vapor deposition machine, and then aluminum was deposited in a thickness of 100 nm. The shape of the resulting organic thin film solar cell was a square having a size of 2 mm $\times$ 2 mm. The obtained organic thin film solar cell was irradiated with a certain amount of light using a solar simulator (trade name OTENTO-SUNII manufactured by BUNKOUKEIKI Co., Ltd.: AM 1.5G Filter, irradiance 100 mW/$cm^2$), and a current and a voltage generated were measured to determine photoelectric conversion efficiency, a short-circuit current density, an open circuit voltage and a fill factor. The short-circuit current density (Jsc) was 5.34 mA/$cm^2$, the open circuit voltage (Voc) was 0.825 V, the fill factor (ff) was 0.44, and the photoelectric conversion efficiency ($\eta$) was 1.93%.

Comparative Example 1

(Preparation and Evaluation of Organic Thin Film Solar Cell)

An organic thin film solar cell was prepared in the same manner as in Example 1 except for using the polymer B in place of the polymer A as a polymer compound and evaluated. Consequently, Jsc was 3.17 mA/$cm^2$, Voc was 0.800 V, ff was 0.402, and the photoelectric conversion efficiency ($\eta$) was 1.01%.

Example 2

(Preparation and Evaluation of Organic Thin Film Solar Cell)

An organic thin film solar cell was prepared in the same manner as in Example 1 except for using the polymer C in place of the polymer A as a polymer compound and evaluated.
Consequently, Jsc was 5. 91 mA/$cm^2$, Voc was 0.947 V, ff was 0.495, and the photoelectric conversion efficiency ($\eta$) was 2.77%.

Example 3

(Preparation and Evaluation of Organic Thin Film Solar Cell)

An organic thin film solar cell was prepared in the same manner as in Example 1 except for using the polymer D in place of the polymer A as a polymer compound and evaluated. Consequently, Jsc was 5.79 mA/$cm^2$, Voc was 0.971 V, ff was 0.489, and the photoelectric conversion efficiency ($\eta$) was 2.75%.

Example 4

(Preparation and Evaluation of Organic Thin Film Solar Cell)

An organic thin film solar cell was prepared in the same manner as in Example 1 except for using the polymer E in place of the polymer A as a polymer compound and evaluated. Consequently, Jsc was 5. 38 mA/$cm^2$, Voc was 0. 957 V, ff was 0. 389, and the photoelectric conversion efficiency ($\eta$) was 2.00%.

Example 5

(Preparation and Evaluation of Organic Thin Film Solar Cell)

An organic thin film solar cell was prepared in the same manner as in Example 1 except for using an ortho-dichlorobenzene solution (a weight ratio of polymer C to PCBM is 1/3) containing the polymer C in place of the polymer A as a polymer compound and C70 PCBM (phenyl-$C_{71}$-butyric acid methyl ester, manufactured by Frontier Carbon Corp.) in place of the C60 PCBM, and evaluated. Consequently, Jsc was 8.00 mA/$cm^2$, Voc was 0. 998 V, ff was 0.486, and the photoelectric conversion efficiency ($\eta$) was 3.88%.

Example 6

(Preparation and Evaluation of Organic Thin Film Solar Cell)

An organic thin film solar cell was prepared in the same manner as in Example 1 except for using an ortho-dichlorobenzene solution (a weight ratio of P3HT to polymer C is 1/1) containing poly(3-hexylthiophene-2,5-diyl) (P3HT) (REGIOREGULAR, manufactured by Merck Ltd., trade name lisicon SP001) in place of the polymer A as a polymer compound and the polymer C in place of the C60 PCBM, and evaluated. Consequently, Jsc was 1.27mA/$cm^2$, Voc was 1.06 V, ff was 0.33, and the photoelectric conversion efficiency ($\eta$) was 0.44%.

Comparative Example 2

(Preparation and Evaluation of Organic Thin Film Solar Cell)

An organic thin film solar cell was prepared in the same manner as in Example 1 except for using an ortho-dichlorobenzene solution (a weight ratio of P3HT to polymer B is 1/1) containing P3HT in place of the polymer A as a polymer compound and the polymer B in place of the G60 PCBM, and evaluated. Consequently, Jsc was 0.54 mA/$cm^2$, Voc was 1.07 V, ff was 0.29, and the photoelectric conversion efficiency ($\eta$) was 0.17%.

Industrial Applicability

The photoelectric conversion element of the present invention is extremely industrially useful since it has high photoelectric conversion efficiency.

## Claims

1. A photoelectric conversion element comprising a pair of electrodes, at least one of which is transparent or translucent, and a photoactive layer provided between the electrodes, wherein the photoactive layer contains an electron donating compound and an electron accepting compound, and the electron donating compound or the electron accepting compound is a polymer compound having a repeating unit represented by the following formula (I), and the proportion of the repeating unit represented by the formula (I) is the highest among all of the repeating units contained in the polymer compound:

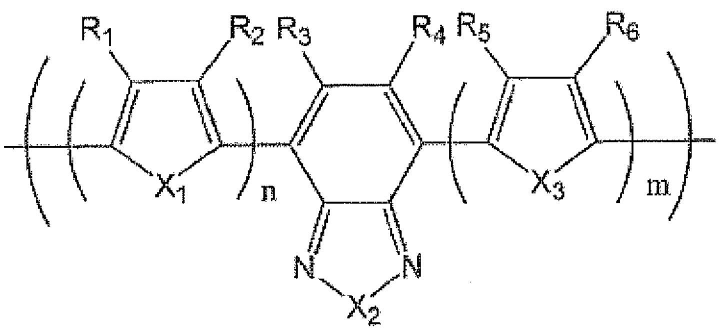

(I)

wherein $R_1$, $R_2$, $R_3$, $R_4$, $R_5$ and $R_6$ are the same or different, represent a hydrogen atom or a substituent, and may be linked with one another to form a cyclic structure; $X_1$, $X_2$ and $X_3$ are the same or different and represent a sulfur atom, an oxygen atom, a selenium atom, $-N(R_7)-$ or $-CR_8=CR_9-$; $R_7$, $R_8$, and $R_9$ are the same or different and represent a hydrogen atom or a substituent; and n and m are the same or different and represent an integer of 0 to 5; and when a plurality of $R_1$s, $R_2$s, $R_5$s, $R_6$s, $X_1$s or $X_3$s respectively exist, they may be the same or different.

**2.** The photoelectric conversion element according to claim 1, wherein n and m are an integer of 1 to 3.

**3.** The photoelectric conversion element according to claim 1 or 2, wherein $X_1$, $X_2$ and $X_3$ are a sulfur atom, respectively.

**4.** The photoelectric conversion element according to any one of claims 1 to 3, wherein an amount of the repeating unit represented by the formula (I) is more than 50% of a total of all repeating units in the polymer compound.

**5.** The photoelectric conversion element according to claim 4, wherein an amount of the repeating unit represented by the formula (I) is 52% or more of a total of all repeating units in the polymer compound.

**6.** The photoelectric conversion element according to any one of claims 1 to 4, wherein an amount of the repeating unit represented by the formula (I) is less than 100% of a total of all repeating units in the polymer compound.

**7.** The photoelectric conversion element according to claim 6, wherein an amount of the repeating unit represented by the formula (I) is 98% or less of a total of all repeating units in the polymer compound.

**8.** The photoelectric conversion element according to any one of claims 1 to 7, wherein the polymer compound further includes a repeating unit represented by the formula (II):

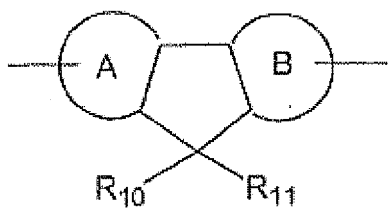

(II)

wherein a ring A and a ring B are the same or different and represent an aromatic ring, and $R_{10}$ and $R_{11}$ are the same or different, and represent a hydrogen atom or a substituent, and may be linked with each other to form a cyclic structure.

**9.** The photoelectric conversion element according to claim 8, wherein the proportion of the repeating unit represented by the formula (II) is the second highest after the proportion of the repeating unit represented by the formula (I) among all of the repeating units contained in the polymer compound.

**10.** The photoelectric conversion element according to claim 8, wherein the repeating units in the polymer compound are only the repeating unit represented by the formula (I) and the repeating unit represented by the formula (II).

**11.** The photoelectric conversion element according to any one of claims 1 to 10, wherein $R_1$, $R_2$, $R_5$ and $R_6$ are a hydrogen atom.

**12.** The photoelectric conversion element according to any one of claims 1 to 11, wherein $R_3$ and $R_4$ are a hydrogen atom.

**13.** The photoelectric conversion element according to any one of claims 8 to 12, wherein $R_{10}$ and $R_{11}$ are a hydrocarbon group.

**14.** The photoelectric conversion element according to claim 13, wherein $R_{10}$ and $R_{11}$ are an alkyl group.

**15.** The photoelectric conversion element according to claim 13 or 14, wherein $R_{10}$ has 12 or more carbon atoms and $R_{11}$ has 12 or more carbon atoms.

**16.** The photoelectric conversion element according to any one of claims 8 to 15, wherein the ring A and the ring B are composed of from a five-membered ring to a ten-membered ring.

**17.** The photoelectric conversion element according to claim 16, wherein the ring A and the ring B are a benzene ring or a naphthalene ring.

**18.** The photoelectric conversion element according to any one of claims 1 to 17, wherein an electron donating compound is the polymer compound including repeating unit represented by the formula (I) and an electron accepting compound is a polymer compound having a thiophene structure.

**19.** The photoelectric conversion element according to any one of claims 1 to 17, wherein an electron accepting compound is the polymer compound having a repeating unit represented by the formula (I) and an electron donating compound is a polymer compound having a thiophene structure.

**20.** The photoelectric conversion element according to claim 18 or 19, wherein the polymer compound having a thiophene structure is a polythiophene homopolymers.

**21.** An image sensor comprising the photoelectric conversion element according to any one of claims 1 to 20.

**22.** A polymer compound including repeating units represented by the formula (I), and the proportion of the repeating unit represented by the formula (I) is the highest among all of the repeating units contained in the polymer compound:

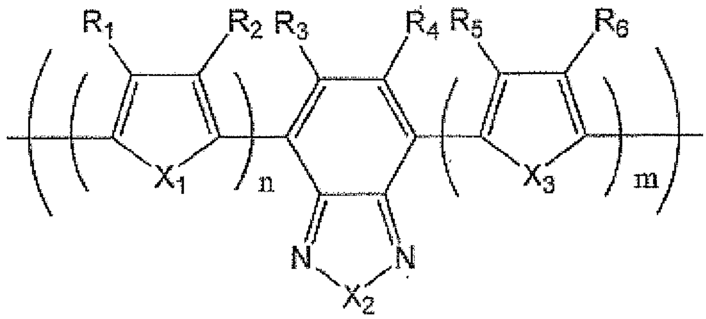

(I)

wherein $R_1$, $R_2$, $R_3$, $R_4$, $R_5$ and $R_6$ are the same or different and represent a hydrogen atom or a substituent, and may be linked with one another to form a cyclic structure; $X_1$, $X_2$ and $X_3$ are the same or different and represent a sulfur atom, an oxygen atom, a selenium atom, $-N(R_7)-$ or $-CR_8=CR_9-$; $R_7$, $R_8$, and $R_9$ are the same or different and represent a hydrogen atom or a substituent; and n and m are the same or different and represent an integer of 0 to 5; and when a plurality of $R_1$s, $R_2$s, $R_3$s, $R_6$s, $X_1$s or $X_3$s respectively exist, they may be the same or different.

**23.** The polymer compound according to claim 22, wherein n and m are an integer of 1 to 3.

**24.** The polymer compound according to claim 22 or 23, wherein $X_1$, $X_2$ and $X_3$ are a sulfur atom, respectively.

**25.** The polymer compound according to any one of claims 22 to 24, wherein an amount of the repeating unit represented by the formula (I) is more than 50% of a total of all repeating units in the polymer compound.

**26.** The polymer compound according to claim 25, wherein an amount of the repeating unit represented by the formula (I) is 52% or more of a total of all repeating units in the polymer compound.

**27.** The polymer compound according to any one of claims 22 to 25, wherein an amount of the repeating unit represented by the formula (I) is less than 100% of a total of all repeating units in the polymer compound.

**28.** The polymer compound according to claim 27, wherein an amount of the repeating unit represented by the formula (I) is 98% or less of a total of all repeating units in the polymer compound.

**29.** The polymer compound according to any one of claims 22 to 28, further including a repeating unit represented by the formula (II):

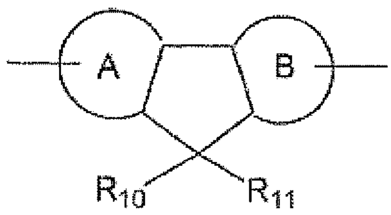

(II)

wherein a ring A and a ring B are the same or different and represent an aromatic ring; and $R_{10}$ and $R_{11}$ are the same or different and represent a hydrogen atom or a substituent, and may be linked with each other to form a cyclic structure.

**30.** The polymer compound according to claim 29, wherein the proportion of the repeating unit represented by the formula (II) is the second highest after the proportion of the repeating unit represented by the formula (I) among all of the repeating units contained in the polymer compound.

**31.** The polymer compound according to claim 29, wherein the repeating units in the polymer compound are only the repeating unit represented by the formula (I) and the repeating unit represented by the formula (II).

**32.** The polymer compound according to any one of claims 22 to 31, wherein $R_1$, $R_2$, $R_5$ and $R_6$ are a hydrogen atom.

**33.** The polymer compound according to any one of claims 22 to 32, wherein $R_3$ and $R_4$ are a hydrogen atom.

**34.** The polymer compound according to any one of claims 29 to 33, wherein $R_{10}$ and $R_{11}$ are a hydrocarbon group.

**35.** The polymer compound according to claim 34, wherein $R_{10}$ and $R_{11}$ are an alkyl group.

**36.** The polymer compound according to claim 34 or 35, wherein $R_{10}$ has 12 or more carbon atoms and $R_{11}$ has 12 or more carbon atoms.

**37.** The polymer compound according to any one of claims 29 to 36, wherein the ring A and the ring B are composed of from a five-membered ring to a ten-membered ring.

**38.** The polymer compound according to claim 37, wherein the ring A and the ring B are a benzene ring or a naphthalene ring.

**INTERNATIONAL SEARCH REPORT**

International application No.
PCT/JP2009/064214

A. CLASSIFICATION OF SUBJECT MATTER
*H01L51/42*(2006.01)i, *C08G61/12*(2006.01)i

According to International Patent Classification (IPC) or to both national classification and IPC

B. FIELDS SEARCHED

Minimum documentation searched (classification system followed by classification symbols)
H01L51/42, C08G61/12

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)
CA/REGISTRY(STN)

C. DOCUMENTS CONSIDERED TO BE RELEVANT

| Category* | Citation of document, with indication, where appropriate, of the relevant passages | Relevant to claim No. |
|---|---|---|
| X<br><br>A | Adv. Mater., 2003, Vol. 15 (12), p. 988-91 | 1-4,8-17,<br>21-25,29-38<br>5,26 |
| X<br><br>A | Appl. Phys. A, 2004, Vol. 79, p. 31-5 | 1-4,8-17,<br>21-25,29-38<br>5,26 |
| X<br><br>A | JP 2002-536492 A (The Dow Chemical Co.),<br>29 October 2002 (29.10.2002),<br>claims; paragraph [0022]; examples (table 1, copolymer 19-23)<br>& US 6353083 B1 & EP 1155096 A<br>& WO 2000/046321 A1 & DE 69924155 D<br>& DE 69924155 T & CA 2360644 A<br>& TW 577910 B & CN 1337987 A | 1-4,8-17,<br>21-25,29-38<br>5,26 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 05 November, 2009 (05.11.09) | 17 November, 2009 (17.11.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.
PCT/JP2009/064214

C (Continuation). DOCUMENTS CONSIDERED TO BE RELEVANT

| Category* | Citation of document, with indication, where appropriate, of the relevant passages | Relevant to claim No. |
|---|---|---|
| X<br>A | Chemical Physics Letters, 2006, Vol. 422, p. 488-91 | 1-5,21-26<br>8-17,29-38 |
| X<br>A | Polymer Bulletin, 2005, Vol. 55, p. 157-64 | 1-5,21-26<br>8-17,29-38 |
| X<br><br>A | JP 2004-534863 A (Cambridge Display Technology Ltd.),<br>18 November 2004 (18.11.2004),<br>claims; paragraph [0054]; examples<br>& US 2004/0115473 A1 & GB 101824 D<br>& GB 114538 D & EP 1366046 A<br>& WO 2002/059121 A1 & DE 60215464 D<br>& DE 60215464 T & AT 342900 T<br>& HK 1061019 A & CN 1487937 A | 1-4,8-17,<br>21-25,29-38<br>5,26 |
| X<br><br>A | JP 2003-519266 A (Cambridge Display Technology Ltd.),<br>17 June 2003 (17.06.2003),<br>claims; paragraph [0008]<br>& US 2003/0186079 A1 & GB 91 D<br>& GB 9805476 A & EP 1244723 A<br>& WO 2000/055927 A1 | 1-4,8-17,<br>21-25,29-38<br>5,26 |
| X<br>A | JP 2005-239790 A (Sanyo Electric Co., Ltd.),<br>08 September 2005 (08.09.2005),<br>claims; examples<br>(Family: none) | 22-25,29-38<br>1-5,8-17,21,<br>26 |
| A | Macromolecules, 2002, Vol. 35, p. 6094-100 | 1-5,8-17,<br>21-26,29-38 |
| A | WO 2008/041597 A1 (Sumitomo Chemical Co., Ltd.),<br>10 April 2008 (10.04.2008),<br>claims; entire text<br>& JP 2008-106239 A & JP 2008-106240 A<br>& JP 2008-109114 A & EP 2067806 A | 1-5,8-17,<br>21-26,29-38 |
| P,X<br><br>P,A | Journal of Polymer Science: Part A: Polymer Chemistry, 2008.08.12, Vol. 46, p. 6175-84 | 1-4,8-17,<br>21-25,29-38<br>5,26 |

Form PCT/ISA/210 (continuation of second sheet) (April 2007)

**INTERNATIONAL SEARCH REPORT**

International application No.
PCT/JP2009/064214

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:

See extra sheet.

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☒ No required additional search fees were timely paid by the applicant. Consequently, this international search report is restricted to the invention first mentioned in the claims; it is covered by claims Nos.:
Claims 1 to 5, 8 to 17, 21 to 26, and 29 to 38.

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2007)

**INTERNATIONAL SEARCH REPORT**

International application No.
PCT/JP2009/064214

Claims 4 to 21 and 25 to 38

Working examples etc. in the description of this application does not demonstrate the synthesis of a polymer compound in which "the total of the repeating units represented by formula (I) is more than 50 % of the total of all the repeating units of the polymer compound". In the working examples, the proportion of repeating units "calculated from charge ratio" is described. However, whether the proportion of repeating units in the produced polymer compound is actually equal to the calculated proportion of repeating units is not described. When a polymer is synthesized from "monomer (1)" and "monomer (2)" in the working examples, the proportion of the repeating units in the polymer compound is 1: 1 independently of the charge ratio and, thus, it is not recognized that the polymer compound in which "the total of the repeating units represented by formula (I) is more than 50 % of the total of all the repeating units of the polymer compound" is synthesized.

Therefore, the inventions defined in the claims cannot be said to be disclosed within the meaning of PCT Article 5 and cannot be said to be adequately supported within the meaning of PCT Article 6.

**INTERNATIONAL SEARCH REPORT**

International application No.
PCT/JP2009/064214

Continuation of Box No.III of continuation of first sheet(2)

The "photoelectric conversion element" defined in claims 1 to 3 of this application is described in the following documents 1 to 3 and thus is not novel and does not have a special technical feature.
Document 1; Adv. Mater., 2003, Vol. 15 (12), p. 988 to 91
Document 2; Appl. Phys. A, 2004, Vol. 79, p. 31 to 5
Document 3; JP 2002-536492 A (The Dow Chemical Co.), 29 October 2002 (29.10.2002), claims, [0022], Examples (copolymers 19 to 23 in table 1) & US 6353083 B1 & EP 1155096 A & WO 2000/046321 A1 & DE 69924155 D & DE 69924155 T & CA 2360644 A & TW 577910 B & CN 1337987 A

Documents 1 to 3 state that "the polymer compound comprising repeating units represented by formula (I)" in claim 1 of this application is used, for example, in solar cells. (Particularly, see fig. 1 in document 1, fig. 1 in document 2, claims in document 3, [0022], and Examples (copolymers 19 to 23 in table 1)). In the polymer compound stated in the above documents 1 to 3, 50% of "the repeating units represented by formula (I)" of the total of all the repeating unit, and the proportion of the repeating units represented by formula (I) in all the repeating units is the highest.

The "photoelectric conversion element" defined in claims 1 to 5 of this application is described in the following documents 4 and 5 and thus is not novel and does not have a special technical feature.
Document 4; Chemical Physics Letters, 2006, Vol. 422, p. 488 to 91
Document 5; Polymer Bulletin, 2005, Vol. 55, p. 157 to 64

Accordingly, there is no special technical feature common to the inventions of claims 1 to 38, and, thus, the inventions of claims 1 to 38 are not so linked as to form a single general inventive concept.

Further, the inventions of claims 1 to 38 include four inventions linked to each other through the following special technical features.

The inventions of claims 1 to 5 not having a special technical feature are classified into (invention 1).

(Invention 1) The inventions of claims 1 to 5, the inventions other than the following (invention 2) among the inventions of claims 8 to 17, the invention of claim 21, the inventions of claims 22 to 26, and the inventions other than the following (invention 2) among the inventions of claims 29 to 38

The photoelectric conversion element "comprising repeating units represented by formula (II)", and the invention directed to the polymer compound.

(Invention 2) The inventions of claims 6 and 7, the inventions that are included in the inventions of claims 8 to 17 and refer to claim 6, the inventions of claims 27 and 28, and the inventions that are included in the inventions of claims 29 to 38 and refer to claim 27

A photoelectric conversion element in which "les than 100% of the total of the repeating units represented by formula (I) is the total of all the repeating nits of the polymer compound", and the invention directed to the polymer compound.

(Invention 3) The invention of claim 18 and the invention that is included in the invention of claim 20 and refers to claim 18

The invention directed to a photoelectric conversion element in which "the polymer compound comprising repeating units represented by formula (I) is an electron donating compound, and the electron accepting compound is a polymer compound having a thiophene structure".

(continued to next extra sheet)

**INTERNATIONAL SEARCH REPORT**

International application No.
PCT/JP2009/064214

(Invention 4) The invention of claim 19 and the invention that is included in the invention of claim 20 and refers to claim 19

The invention directed to a photoelectric conversion element in which "the electron accepting compound is a polymer compound comprising repeating units represented by formula (I), and the electron donating compound is a polymer compound having a thiophene structure".

When the invention is classifiable into a plurality of the above invention classes, the invention is regarded as belonging to the first invention class.

An international search report was prepared for (invention 1).

Form PCT/ISA/210 (extra sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP HEI945478 A

### Non-patent literature cited in the description

- *Applied Physics A,* 2004, vol. 79, 31-35
- *Advanced Material,* 2003, vol. 15, 988